# EUROPEAN PATENT SPECIFICATION

(11) **EP 4 571 338 B1**
(45) Date of publication and mention of the grant of the patent: **11.03.2026**
(21) Application number: 24211048.4
(22) Date of filing: 06.11.2024
(51) Int. Cl.: G01R 31/367, G01R 31/378

(54) **RADIO FREQUENCY (RF) DEVICE BATTERY MONITORING SYSTEM AND RELATED METHODS**
BATTERIEÜBERWACHUNGSSYSTEM FÜR HOCHFREQUENZ (HF)-VORRICHTUNG UND ZUGEHÖRIGE VERFAHREN
SYSTÈME DE SURVEILLANCE DE BATTERIE DE DISPOSITIF RADIOFRÉQUENCE (RF) ET PROCÉDÉS ASSOCIÉS

(30) Priority: 12.12.2023 US 202318536421
(43) Date of publication of application: 18.06.2025
(73) Proprietor: L3Harris Global Communications, Inc., Rochester, NY 14623 (US)
(72) Inventor: TORRES, Myra, Pittsford, 14534 (US); FABRE, Vladimir, Rochester, 14623 (US); ROOS, Christina E., Pennfield, 14526 (US)
(74) Representative: Schmidt, Steffen J.

(56) References cited:
- US-A1- 2012 235 823
- US-A1- 2013 104 232
- US-A1- 2019 114 619
- US-A1- 2023 100 050

## Description

### Technical Field

The present application relates to radio frequency (RF) communications devices, and, more particularly, to battery-powered portable RF devices and related methods including deployment and maintenance.

### Background

For large-scale deployment of radio frequency (RF) devices (radios), such as with government or commercial entities that may deploy numerous personnel in the field at a time, support services and products (sometimes located at radio depots) are used to help ensure that the radios being deployed are ready to support mission objectives. For example, L3Harris designs and delivers radio maintenance and support solutions tailored to unique customer needs. The products can be used to test, maintain and repair numerous radios and accessories, helping to ensure they remain at peak performance levels. Options range from site spares kits to highly automated test systems. These systems allow for factory-level analyses to quickly test radios prior to deployment or to detect issues for in-field repair.

Despite the advantages of such support solutions, further advancements in radio deployment and maintenance capabilities may be desirable in certain applications.

Relevant prior art is disclosed in US 2012/235823 A1. It relates to monitoring for electronic devices such as mobile phones, more particularly to power management and battery life indication schemes for a portable electronic device having a primary battery and a secondary battery, wherein in practice the secondary battery may be considered to be a backup battery.

### Summary

An electronic system according to the invention is defined in independent claim 1. It includes an electronic device including a portable housing, communications circuitry carried by the portable housing, a volatile memory carried by the portable housing and configured to store at least one encryption key, and a non-rechargeable battery carried by the portable housing and coupled to the volatile memory. The non-rechargeable battery may have an internal resistance, and the electronic device may further include an internal resistance measurement circuit carried by the portable housing and configured to measure the internal resistance of the non-rechargeable battery. The electronic device may also include a processor carried by the portable housing and configured to collect and store battery performance data including the measured internal resistance and a corresponding operating parameter, and a rechargeable battery removably coupled to the portable housing and configured to supply power to the volatile memory and with the non-rechargeable battery supplying power to the volatile memory otherwise. The electronic system may further include a controller configured to collect the battery performance data and use machine learning to determine a State of Health (SoH) of the non-rechargeable battery.

In an example embodiment, the controller may be configured to generate run to fail (RTF) training data for the non-rechargeable battery based upon different combinations of internal resistance measurements and operating parameters and determine the SoH of the non-rechargeable battery based upon the machine learning pattern matching and the downloaded battery performance data. Furthermore, the controller may also be configured to generate an alert when the SoH falls below a SoH threshold.

In an example implementation, the machine learning may be performed by an Artificial Neural network (ANN). The machine learning may include Dynamic Time Warping (DTW), for example. Also, by way of example, the operating parameter may comprise at least one of frequency, voltage, current, and temperature. Furthermore, the controller may comprise a Maintenance as a Service (MAAS) cloud computing controller, for example.

In an example embodiment, the communications circuitry may comprise a radio frequency (RF) transceiver, the processor may be configured to discontinue RF communications if the at least one encryption key is erased, and the non-rechargeable battery may be configured to supply power to the volatile memory when the rechargeable battery is uncoupled from the portable housing so that the at least one encryption key is not erased. In some embodiments, the internal resistance measurement circuit may be configured to measure the internal resistance values based upon impedance monitoring via pulse current measurement.

A related controller, such as the one described briefly above, and method are also provided. The method may include operating an electronic device, such as the one described briefly above, and using a controller to collect the battery performance data and determine a SoH of the non-rechargeable battery based upon machine learning.

### Brief Description of the Drawings

FIG. 1 is a schematic block diagram of a radio frequency (RF) system in accordance with an example embodiment.
FIG. 2 is a schematic block diagram of another example implementation of the RF system of FIG. 1.
FIG. 3 is a schematic block diagram of still another example implementation of the RF system of FIG. 1.
FIG. 4 is as schematic block diagram illustrating radio State of Health (SoH) training approaches which may be used in accordance with example embodiments.
FIG. 5 is a schematic block diagram illustrating an example distributed RF system implementation in accordance with an example embodiment.
FIG. 6 is a schematic block diagram illustrating an example Maintenance as a Service (MaaS) implementation of an RF system in accordance with an example embodiment.
FIGS. 7A and 7B are graphs of degradation vs. time and target points vs reference points, respectively, for an example controller implementation which utilizes a Dynamic Time Warping machine learning implementation in accordance with an example embodiment.
FIG. 8 is a flow diagram illustrating method aspects in accordance with an example embodiment.

### Detailed Description

The present description is made with reference to the accompanying drawings, in which exemplary embodiments are shown. However, many different embodiments may be used, and thus the description should not be construed as limited to the embodiments set forth herein. Rather, these embodiments are provided so that this disclosure will be thorough and complete. Like numbers refer to like elements throughout, and prime notation is used to indicate like elements in different embodiments.

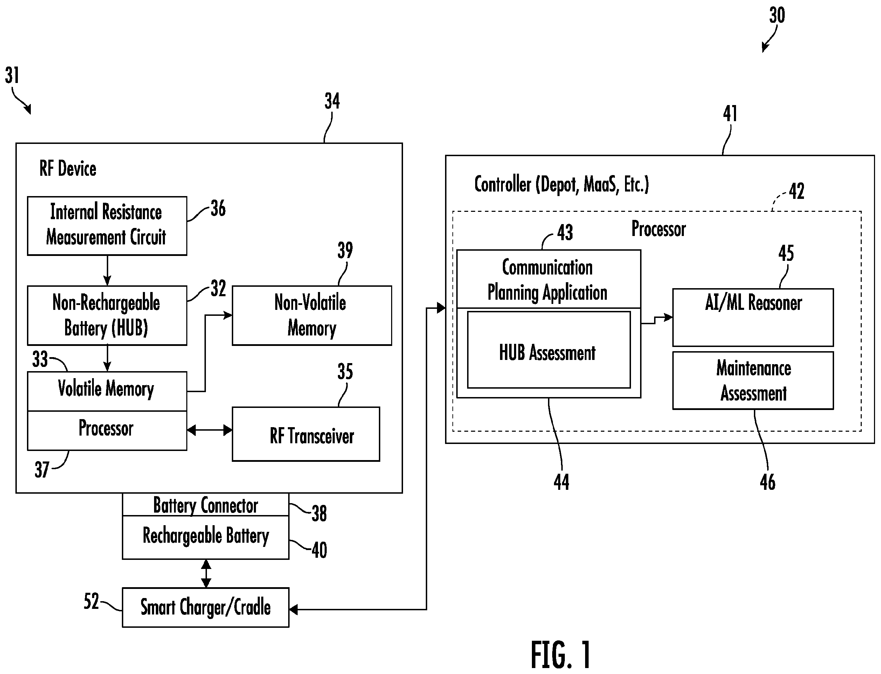

Referring initially to FIG. 1, an example radio frequency (RF) system 30 which provides enhanced monitoring and maintenance features for an RF device(s) 31 (radios) is now described. By way of background, some radios such as the RF device 31 include non-rechargeable Hold Up Batteries (HUBs) 32 to host the crypto keys for encrypted communication. When the HUB 32 loses power, the volatile memory 33 is unable to maintain storage of the encryption keys, resulting in a loss of encryption, which disables the radio (i.e., it is "bricked"). Prior efforts have focused on providing radio users with alerts such as "low hub warning" when the battery source is approaching the threshold of power loss. However, this alert typically comes too late and may pose a mission risk because rekeying and replacement of the HUB 32 must be performed at a depot or other authorized location, thus leaving the radio 31 user without communications capabilities.

The foregoing may be especially problematic where radios are in storage for a long period of time, and/or in extreme environments that age and deplete the HUB 32 quickly. Furthermore, non-rechargeable power sources such as HUBs also present challenges in degradation detection. As an example, LiSoCl₂ batteries have a very flat discharge profile which do not provide a very good early warning of imminent failure.

The ability to assess the remaining useful life of HUBs on many radios is limited and, in some cases, would require at least partial disassembly of the radio. Some approaches use a Coulomb counter to measure the discharge capacity of batteries on radios, however this may be undesirable with respect to power sources for volatile memories such as HUB batteries for several reasons. First, Coulomb counter circuitry consumes current that takes away from the available capacity, and in the case of certain chemistries voltage monitoring is not effective since the discharge profile of the battery is extremely flat all the way to end of life, as noted above. Second, non-operating and operating storage conditions continue to degrade the battery, especially if they are exposed to extreme temperature conditions. In these conditions, Coulomb counters are marginally effective and demonstrate high uncertainty. Third, such approaches for the assessment of remaining useful life generally do not address non-rechargeable applications. That is, most such approaches focus on the broader rechargeable application space for electric vehicles (EVs) and the like.

The system 30 may advantageously overcome these technical problems by providing an approach to assess radio health prior to deployment, and address considerations such as: whether the radio has sufficient HUB 32 life to meet the mission objective; the remaining useful life on the HUB, prior to mission deployment; and assessing battery useful life based on the actual duty cycle of the radio 31 it is paired with. Generally speaking, the system 30 uses one or more machine learning (ML) algorithms to assess the state of charge (SoC) from the radio factory to the maintenance depot where it is provisioned, deployed, and keyed. The risk of encryption loss to the radio user is significantly reduced by assessing the state-of-health (SoH) of the radio prior to deployment. The maintainer may also assess age related degradation and plan for HUB 32 replacements, thus greatly reducing the risk of a degraded radio HUB being deployed for a mission.

The radio 31 illustratively includes a portable housing 34, an RF transceiver 35 carried by the portable housing, the volatile memory 33 carried by the portable housing which is configured to store one or more encryption keys, as noted above, and the non-rechargeable HUB 32 also carried by the portable housing and coupled to the volatile memory 33, with the HUB has an internal resistance, and the radio 31 further illustratively includes an internal resistance measurement circuit 36 carried by the portable housing and configured to measure the internal resistance of the non-rechargeable HUB 32 at different times, as will be discussed further below. The RF device 31 also illustratively includes a processor 37 carried by the portable housing and coupled to the RF transceiver 35, the volatile memory 33, and the internal resistance measurement circuit 36.

The processor 32 is configured to operate the RF transceiver 35 to send and receive RF communication signals, and to store in the volatile memory 33 battery performance data including the measured internal resistance along with a corresponding operating parameter at a time each internal resistance is measured, as will also be discussed further below. The radio 31 further illustratively includes a battery connector 38 carried by the portable housing 34 that is electrically coupled to the RF transceiver 35, the volatile memory 33, the internal resistance measurement circuit 36, and the processor 37. The radio 34 further illustratively includes non-volatile memory 39 in which the battery performance data may be stored.

The RF system 30 also illustratively includes one or more rechargeable batteries 40 removably coupled to the battery connector 38. When connected to the battery connector 38, the rechargeable battery 40 supplies power to the RF transceiver 35, the volatile memory 33, the internal resistance measurement circuit 36, and the processor 37. However, as noted above, the HUB 32 supplies power to the volatile memory 33 when the rechargeable battery is disconnected from the battery port 38 (or connected but below a minimum charge level/discharged). The radio 31 and rechargeable battery 40 (or just the rechargeable battery in some embodiments) may be connected to a smart charger/cradle 52 for docking/charging, as will be discussed further below.

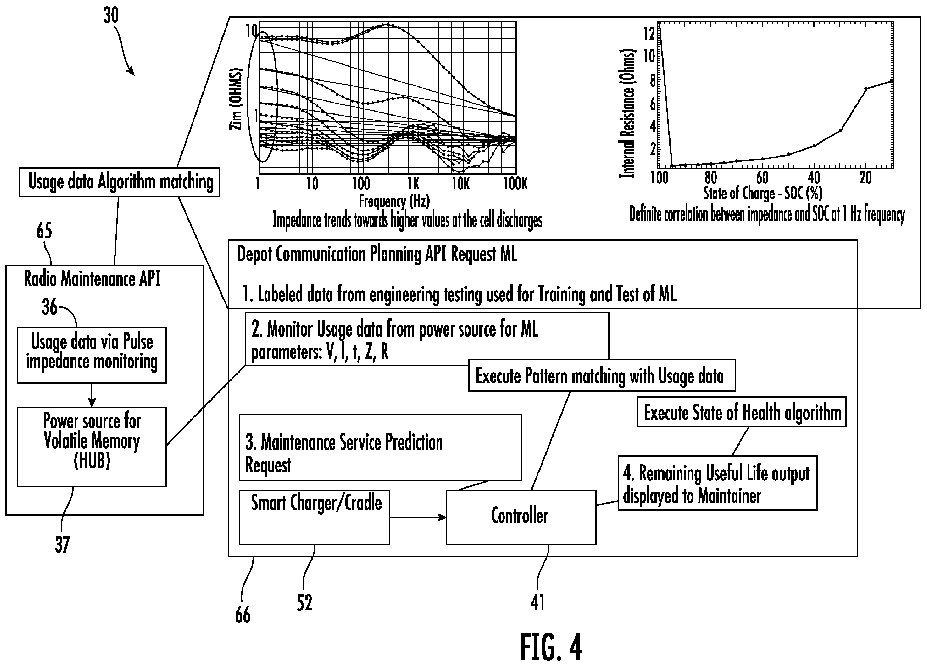

The RF system 30 further illustratively includes a controller 41 (see FIG. 4), which in turn includes a processor 42 configured to run a communication planning app 43 including a HUB assessment module 44, an artificial intelligence (AI)/machine learning (ML) reasoner module 45, and a maintenance assessment module 46. Generally speaking, the modules 44-46 implemented by the processor 42 generates run to fail (RTF) training data for the HUB 32 based upon different combinations of internal resistance measurements and RF operating parameters, download the battery performance data from the non-volatile memory 39 and perform machine learning pattern matching based upon the battery performance data and the RTF training data, and determine an SoH of the HUB based upon the machine learning pattern matching and the downloaded battery performance data. The maintenance assessment module 46 may further generate an alert when the SoH falls below a SoH threshold, for example.

The controller 41 may be deployed at a depot, and/or as part of a Maintenance as a Service (MaaS) cloud controller, for example. It advantageously provides a comprehensive approach that uses training data which may be developed in a laboratory (discussed further below with reference to FIG. 4) that correlates power source (e.g., HUB) measurements to available radio operating parameters. This provides a comprehensive and flexible approach to addressing remaining useful life of HUB batteries 32 across a large number of radios 31. Moreover, it may accommodate both legacy devices as well as future radios, and it may be deployed for other similar applications that involves volatile memory storage of critical parameters, as will be discussed further below.

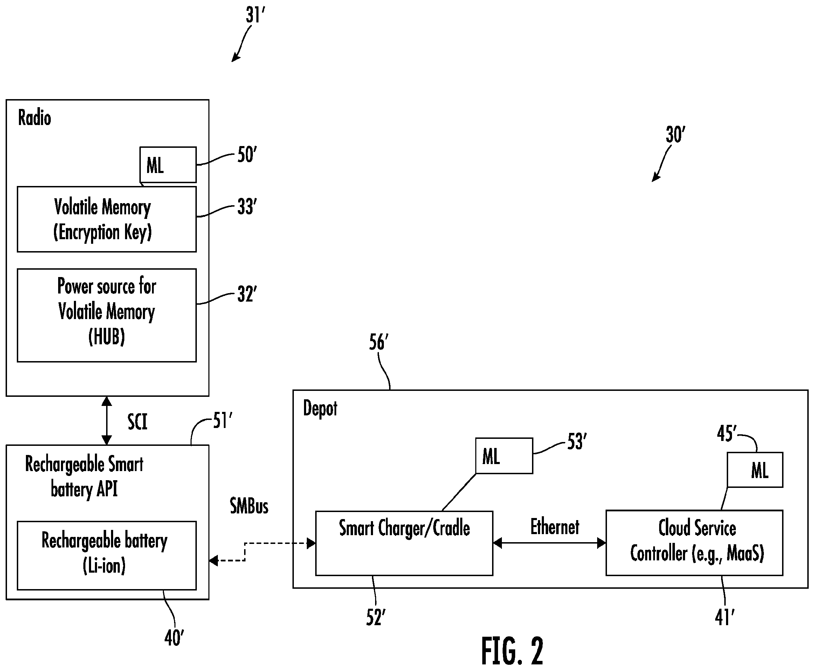

Referring additionally to FIG. 2, in some embodiments an ML learning module 50' may also be deployed on the radio 31' for collecting the battery performance data (e.g., via a data input/output port, Serial Communication Interface (SCI)), and the rechargeable battery 40' may have incorporated therewith a software API 50' to communicate the battery performance data to a smart charger/cradle 52' (e.g., via a system management bus, SMBus), which may be located at a depot 56'. However, it should be noted that in some embodiments smart chargers/cradles 52' may be located in the field (i.e., not at the depot 56'), and they may communicate battery performance data to the controller 41' via other types of wired or wireless links.

In the present example, the controller 41' is a cloud (MaaS) services device which operates the ML reasoner module 45', and the smart charger/cradle 52' also has an ML module 53' associated therewith. In this regard, the various ML functions may be distributed across the radio 31', smart charger/cradle 52', and MaaS controller 41'. For example, the radio ML module 50' may perform the basic operations required to collect/format the battery performance data to avoid the need for extensive processing resources and power consumption at the radio 31'. Moreover, the ML module 53' at the depot 56' may perform comparisons/recommendations based upon the received battery performance data and training data, and the ML module 45' may be responsible for generation and updating the ML training data for the ML module(s) 53' to use at the depot or in the field for battery maintenance assessment.

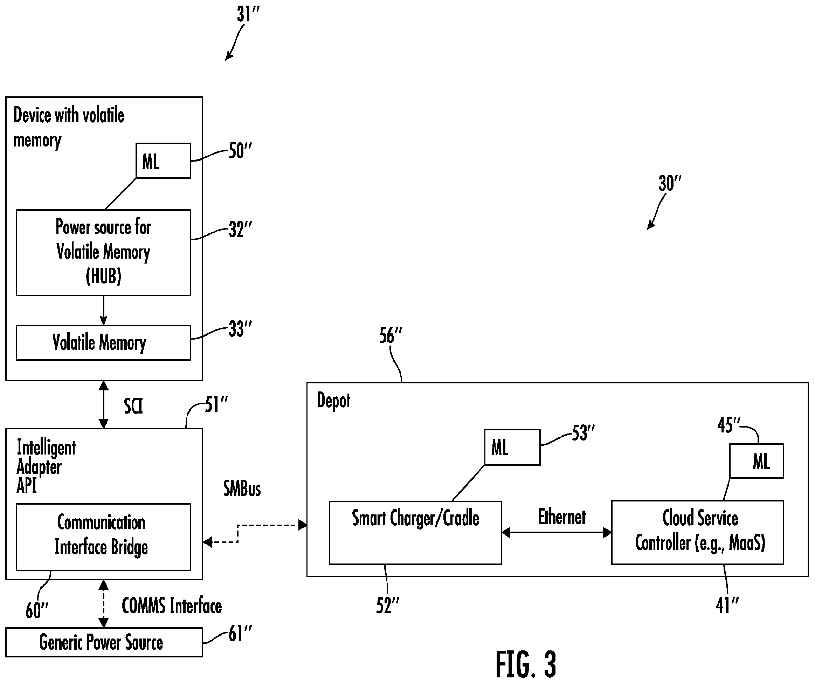

Referring additionally to FIG. 3, another similar implementation of the system 30" for electronic devices 31" (which may or may not have RF capabilities) that include a volatile memory 33'' and a HUB 32", and for which power health maintenance decisions are required, is now described. Examples of such electronic devices 31'' include Pico hubs, crypto modules, etc. As with the embodiment of FIG. 2, the distributed ML modules 45", 50", 53" enable monitoring of relevant battery health data and maintenance for a power health state of the device 31". Here, the battery performance data is retrieved from the device 31" via an API 51'' and associated communication interface bridge, which receive power via a power source 61" (e.g., via a COMMS interface).

Turning now to FIG. 4, an example implementation of components from the system 30, as well as an associated approach for predicting remaining useful life are now described. This approach incorporates HUB characteristics for different types of HUBs from bench testing where data may be labeled for useable and degraded (unusable) states. Measured impedance or resistance values from the training measurements provide a correlation to ML monitored radio parameters from the measurement circuit 36 (which may be retrieved via a radio maintenance API 65, for example), as noted above, and a depot maintenance API 66 enables a determination of remaining useable life such that the controller 41 may return indications for service.

At step 1 of FIG. 4, labeled data from the engineering/benchmark testing is used for training and testing of the machine learning. More particularly, the ML approach leverages engineering models with RTF data for the HUB batteries 37, including Bode plots (impedance vs frequency in logarithm scale) where the impedance profiles of the batteries identify failing batteries at low frequency. At a given measurement frequency (e.g., 1Hz) a State of Charge (SoC) as a percentage of charging capacity may be determined. The engineering models may be generated from multiple engineering sources, including: (1) RTF data from characterization testing; (2) accelerated life test data; (3) RTF data using at different operating conditions; and/or (4) data from different system implementations. The impedance model may be based upon the specific electrochemistry of the particular HUB type, and the SoC is determined as a function of the battery health. With respect to establishing a system impedance model, the HUB SoC correlates to the system state-of-health (SoH), where the system impedance model is populated with the RTF data to become the reference data set (HUB SoC + Usage Radio Data = System SoH).

Generally speaking, the engineering models provide starting RTF data sets that may be augmented for implementation in an ML training and estimation approach. One way to do so is with Dynamic Time Warping (DTW). DTW is a pattern matching algorithm that prepares the engineering model to be transformed into a suitable reference data set that is also suitable for a ML training data set. A benefit of DTW is the ability to use RTF data that has disjointed time sequences.

More particularly, DTW is a graph search technique that pattern matches to disjoint time periods to understand if the stage of behavior has changed significantly and examines for outliers (extreme conditions and other anomalies). Distance is computed from the matching of similar elements between time series. Once the minimum path has been found, this provides a vector of interest that locates the best fit to the plot of interest. Moreover, this establishes the baseline of expected behavior that may be used to develop the reference training set. For the present application DTW may be used in two ways, namely: (1) augmenting the engineering models (SoC) with virtual RTF data; and (2) augmenting radio usage data at both the factory and depot. However, another function is to distinguish anomaly data or trends that the usage data is deviating from with respect to the trend in the original reference models. An error function such as root mean square (RMS) may be used to trend the error between both usage data and the estimations.

At step 2, usage data from the HUB 32 is monitored for ML parameters (e.g., voltage, current, temperature, impedance, and/or resistance). As noted above, it may be desirable to keep radio level monitoring (and therefore processing and battery usage) to a minimum. Operating parameter data such as time, temperature and location may be collected, though in some applications not all such data is necessarily collected. However, battery impedance will vary as a result of the external stresses of the radio 31, and the battery SoH correlates to the volatile-memory-health and to the radio SoH. Thus, impedance monitoring on the radio 31 is a beneficial indicator for the SoH. For usage measurement, a current pulse is invoked on the radio 31 and the HUB 32 response is measured by the measurement circuitry 36, from which impedance is calculated.

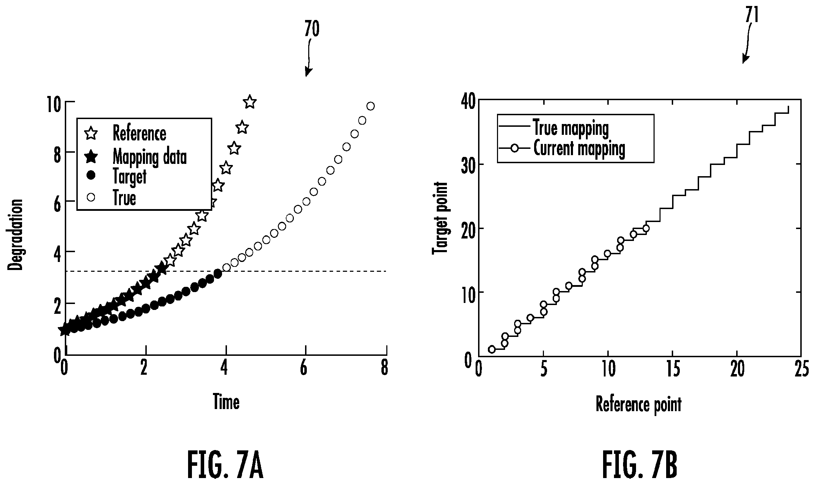

At step 3, a maintenance service prediction request is made. The radio 31 may be provisioned with a reference plot in the form of a matrix. Each time a pulse impedance measurement is executed, an impedance calculation is made. This new data point is added as a "usage" vector from which the DTW algorithm searches the optimal path between the reference point to the target (radio usage) data given at different times. Although the reference plot from the factor may have differing values, as seen in the graph 70 of FIG. 7A where hollow stars are the reference model, and the target (radio) are filled circles that are not aligned. The data trends between the two plots have a linear relationship and are one-to-one correspondence. This assumes that the future mapping path will follow the same trend obtained by DTW up to the current time. Thus, a linear function may be used to predict or extrapolate into the future mapping. Device monitoring now only requires data collection of pulse impedance measurements.

From this measurement a mapping path may be calculated from the new (current) point to its predecessor and to its predicted patch, as shown in graph 71 of FIG. 7B. Once the current point is established the virtual mapping is calculated, these are seen in the plot 70 as data points above the dashed line. The degradation level stays the same, but the time changes based upon the true measurement. This process is repeated for each new pulse impedance measurement and generates a virtual data set. From this, the controller 41 may determine and provide to the maintainer an indication of the remaining useful life of the HUB 32.

Deep learning algorithms may be deployed at the factory provisioning and at the depot workstation for the classification and correlation of patterns in cases where the DTW is detecting anomaly behavior. The reference training set is flexible to support deep learning, and because RTF data was used, the convergence should require minimal layers.

Artificial Neural Network (ANN) is one type of neural networks that may be used, which has a high fault tolerance. It includes input, hidden, and output layers. An advantage of ANN is that it can store and retrieve information on the entire network and is not dependent on a specific database. Thus, if there is significant variation in the radio usage data, the depot controller (e.g., a MaaS controller) may be designed to reach out to the factory and retrieve the original reference model. Since the reference model is a suitable training set, it may be appended with the radio usage data and the ANN algorithm may be invoked for a new health state prediction.

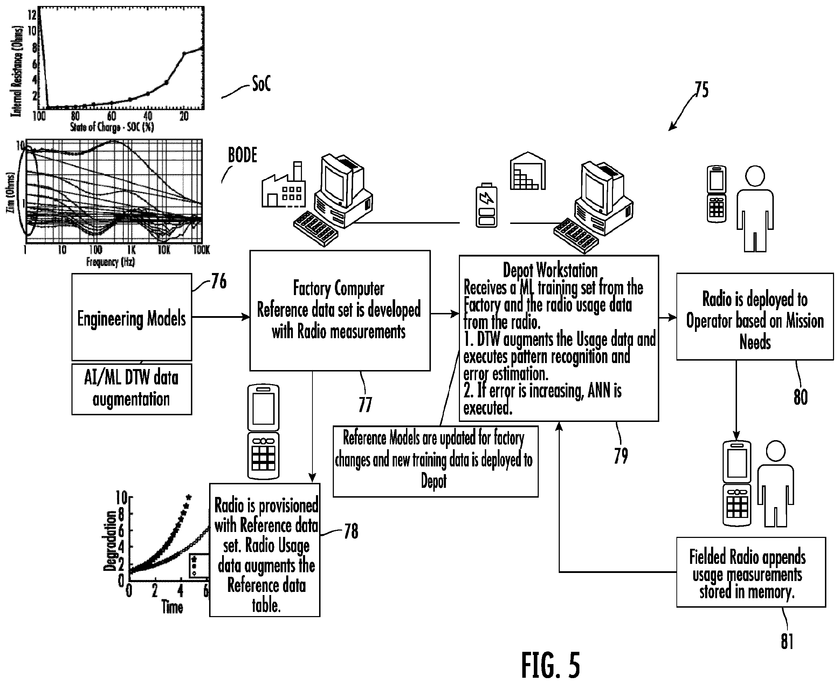

Turning to the flow diagram 75 of FIG. 5, an example implementation is now described which helps to minimize processing operations on the radio 31. More particularly, the engineering models may be used to generate AI/ML training data which is optimized in the factory and deployed as a MaaS cloud service at a depot (Blocks 76-77). The approach begins with component level, validated engineering model Bode plots that are validated with run to fail (RTF) data. From the Bode plots an SoC model may be developed for a given frequency. The RTF data may be captured in a series of plots that are the result of measured electro chemical behavior and impedance behavior. The RTF data may then be further augmented for use with an AI/ML reasoner 45 (e.g., using DTW, etc.), as discussed further above. From the Bode plots an SoC model can be developed for a given frequency that then correlates to the state of charge of the battery. Multiple reference plots may be used that capture the system under various conditions and implementation, if desired.

The radio 31 may be factory installed (provisioned) with an initial set of reference data (Block 78), and the radio usage data may be appended each time the radio executes a pulse impedance measurement. The factory conducts usage measurements during the integration and testing phase which enable predictions at the radio 31 system level.

At Block 79, when the radio comes into the depot, the depot workstation assesses the SoH in an "out of box" unpacking state. The training data from the factory is uploaded to the depot workstation as well as the radio usage data. The depot executes the DTW algorithm to assess if the radio is aligning with the reference data, and if it is, a remaining useful life of the radio 31 can be assessed. If the radio 31 has been stored in extreme conditions and there is significant error, the error function will generate an alert of the drift and that data can be sent in the MaaS logs to the factory. At this time the depot workstation may deploy an alternative prediction of health by deploying an ANN to learn the new behavior and predict the outcome. The ANN uses the same training data set as was used with DTW.

The radio is deployed to the operator (Block 80) based on the radio-health state and the operators-mission needs. The fielded radio continues to append data each time a single pulse impedance measurement is executed, at Block 81. Each time the radio returns to the depot it is assessed based on the latest reference training dataset form the factory. The depot will provide a SoH and may also connect with other asset management applications if they are part of the cloud service, for example.

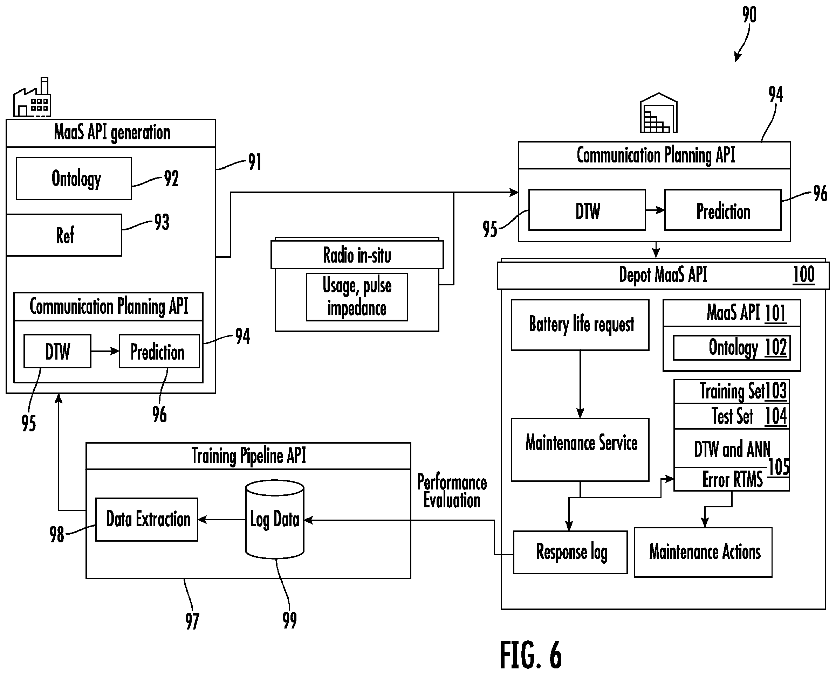

Referring additionally to FIG. 6, an example cloud service system 90 is now described. Cloud applications enable depot deployment wherever a cloud infrastructure is supported. MaaS architecture enables immediate responses from the factory based on inputs across the customer base. In the illustrated example a MaaS API generator 91 (which illustratively includes ontology and reference modules 92, 93) generates communication planning APIs 94, which may be designed to meet the Rest API standard, for example. The APIs 94 illustratively includes DTW and prediction modules 95, 96. Depot applications may be classified as an edge of network application and are unique where the schema may be uncertain or unknown. Thus, an ontology approach may be advantageous where the host application is deployed from the factory. The ontology module 92 addresses security concerns and sets up an approach for a training pipeline API 97, which illustratively includes a data extraction module and data log 99. The pipeline API 97 allows for testing of the API deployment during set up. As the lifecycle evolves and deployment strategies change, the ontology may adapt and be varied for each depot application with a common central management for the API deployment from the factory.

A depot MaaS API 100 illustratively includes a MaaS API 101 with associated ontology module 102, training and test data sets 103, 104, and a DTW/ANN module 105 for SoH/error analysis, as discussed further above. The Depot MaaS API 100 may further handle battery life requests, maintenance services, response logs, and maintenance actions as shown.

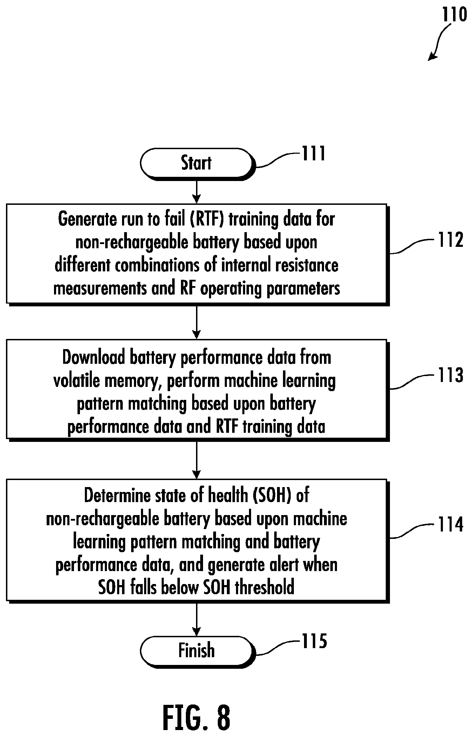

Referring additionally to the flow diagram 110 of FIG. 8, related method aspects are now described. Beginning at Block 111, the controller 41 generates RTF training data for the HUB and device 32 based upon different combinations of internal resistance measurements, diagnostic profiles and RF operating parameters (Block 112), downloads the battery performance data (e.g., from the non-volatile memory 39) and performs machine learning pattern matching based upon the battery performance data and the RTF training data (Block 113). The method further illustratively includes determining a SoH of the HUB and device based upon the machine learning pattern matching and the downloaded battery performance data (Block 114), as discussed further above. The controller 41 may further generate an alert when the SoH falls below a SoH threshold, and if drifting behavior is observed as also noted above. The method of FIG. 8 illustratively concludes at Block 115.

The above-described approach advantageously addresses remaining useful life predictions and maintenance action support for non-rechargeable batteries in volatile memory applications. The approach also addresses unique battery chemistry behaviors including those which exhibit a very flat discharge profile. In addition, this approach may provide a rapid assessment of SoC by employing a single frequency in_situ measurement to assess critical cell impedance correlation with cell state of charge.

Other technical solutions provided by the embodiments set forth above may include providing relatively rapid SoH assessment that correlates radio parameters with bench top characterization data, as well as providing a solution for depot maintainers that addresses the needs of provisioning or deploying radios, and more particularly assessing remaining useful life of the volatile memory 33 power source (HUB 32). The above-described embodiments are in_situ and do not require a hardware sensor and may be deployed via software APIs to address specific use cases. Moreover, these approaches do not require Coulomb counting.

Still another technical advantage includes the ability to predict degradation or imminent failure in power sources for volatile memories by combining engineering laboratory data, radio/device usage and machine learning to provide a rapid state of health assessment at the depot level prior to deployment. Yet another technical advantage is the determination of capacity by using impedance measured at a single frequency using engineering bench top techniques in combination with ML in the radio to predict remaining useable life impacts based on actual radio use and environmental conditions. More particularly, the above-noted embodiments may be used to address new customer use cases and extreme conditions that have detrimental impact to radio volatile memory power health and may include a feedback loop to update the ML algorithms deployed. Furthermore, the ML approach may be adapted for unsupervised learning with partial data and may enable MaaS applications at the depot.

Pulse Impedance measurements for fitness of mission and radio degradation resulting from age and damage. Where an engineering functional model for the overall radio impedance (see FIG. 4) is characterized with a specific use profile that establishes basis of health for the radio. Then, pulse impedance monitoring during field usage is pattern matched to the engineering functional model for fitness of mission, where the ML approach detects drifting behavior that is correlated to the likelihood of degraded functional performance. As an example, damaged solder joints would exhibit a deviated impedance profile and alert the maintainer that this unit may not be suitable fit for mission application. Similarly, degrading behavior in electronic components that contribute to the impedance profile would produce an alert to drifting performance and alert the maintainer about the units' suitability for mission. These drifting parameters can be further associated to secondary models for aging and damage and subsequent maintenance actions.

Many modifications and other embodiments will come to the mind of one skilled in the art having the benefit of the teachings presented in the foregoing descriptions and the associated drawings. Therefore, it is understood that the disclosure is not to be limited to the specific embodiments disclosed, and that modifications and embodiments are intended to be included within the scope of the appended claims.

## Claims

1. An electronic system (30) comprising:
an electronic device (31) comprising
a portable housing (34),
communications circuitry (35) carried by the portable housing,
a volatile memory (33) carried by the portable housing and configured to store at least one encryption key,
a non-rechargeable battery (32) carried by the portable housing and coupled to the volatile memory, the non-rechargeable battery having an internal resistance,
an internal resistance measurement circuit (36) carried by the portable housing and configured to measure the internal resistance of the non-rechargeable battery,
a processor (37) carried by the portable housing and configured to collect and store battery performance data including the measured internal resistance and a corresponding operating parameter, and
a rechargeable battery (40) removably coupled to the portable housing and configured to supply power to the volatile memory and with the non-rechargeable battery supplying power to the volatile memory otherwise; and
a controller (41) configured to collect the battery performance data and use machine learning to determine a State of Health (SoH) of the non-rechargeable battery.

2. The electronic system of claim 1 wherein the controller is configured to:
generate run to fail (RTF) training data for the non-rechargeable battery based upon different combinations of internal resistance measurements and operating parameters; and
determine the SoH of the non-rechargeable battery based upon the machine learning pattern matching and the downloaded battery performance data.

3. The electronic system of claim 1 wherein the controller is configured to generate an alert when the SoH falls below a SoH threshold.

4. The electronic system of claim 1 wherein the machine learning is performed by an Artificial Neural network (ANN).

5. The electronic system of claim 1 wherein the machine learning includes Dynamic Time Warping (DTW).

6. The electronic system of claim 1 wherein the operating parameter comprises at least one of frequency, voltage, current, and temperature.

7. The electronic system of claim 1 wherein the controller comprises a Maintenance as a Service (MAAS) cloud computing controller.

8. The electronic system of claim 1 wherein the communications circuitry comprises a radio frequency (RF) transceiver; wherein the processor is configured to discontinue RF communications if the at least one encryption key is erased; and wherein the non-rechargeable battery is configured to supply power to the volatile memory when the rechargeable battery is uncoupled from the portable housing so that the at least one encryption key is not erased.

9. The electronic system of claim 1 wherein the internal resistance measurement circuit is configured to measure the internal resistance values based upon pulse impedance monitoring.

10. A method of operating an electronic system according to any of claims 1-9.

## Patentansprüche

1. Ein elektronisches System (30) mit:
einem elektronischen Gerät (31), das umfasst
ein tragbares Gehäuse (34),
eine Kommunikationsschaltung (35), die von dem tragbaren Gehäuse getragen wird,
einen flüchtigen Speicher (33), der von dem tragbaren Gehäuse getragen wird und zum Speichern mindestens eines Verschlüsselungsschlüssels konfiguriert ist,
eine nicht wiederaufladbare Batterie (32), die von dem tragbaren Gehäuse getragen wird und mit dem flüchtigen Speicher gekoppelt ist,
wobei die nicht wiederaufladbare Batterie einen Innenwiderstand aufweist,
eine interne Widerstandsmessschaltung (36), die von dem tragbaren Gehäuse getragen wird und so konfiguriert ist, dass sie den internen Widerstand der nicht wiederaufladbaren Batterie misst,
einen Prozessor (37), der von dem tragbaren Gehäuse getragen wird und so konfiguriert ist, dass er Batterieleistungsdaten einschließlich des gemessenen Innenwiderstands und eines entsprechenden Betriebsparameters sammelt und speichert, und
eine wiederaufladbare Batterie (40), die abnehmbar mit dem tragbaren Gehäuse verbunden und so konfiguriert ist, dass sie den flüchtigen Speicher mit Strom versorgt, wobei die nicht wiederaufladbare Batterie ansonsten den flüchtigen Speicher mit Strom versorgt; und
eine Steuereinheit (41), die so konfiguriert ist, dass sie die Batterieleistungsdaten erfasst und mithilfe von maschinellem Lernen den Gesundheitszustand (SoH) der nicht wiederaufladbaren Batterie bestimmt.

2. Das elektronische System nach Anspruch 1, wobei die Steuereinheit konfiguriert ist zum:
Erzeugen von Run-to-Fail-(RTF-)Trainingsdaten für die nicht wiederaufladbare Batterie auf der Grundlage verschiedener Kombinationen von Innenwiderstandsmessungen und Betriebsparametern; und
Bestimmen des SoH der nicht wiederaufladbaren Batterie auf der Grundlage des maschinellen Lernens durch Musterabgleich und der heruntergeladenen Batterieleistungsdaten.

3. Das elektronische System nach Anspruch 1, wobei die Steuereinheit so konfiguriert ist, dass sie eine Warnung generiert, wenn der SoH unter einen SoH-Schwellenwert fällt.

4. Das elektronische System nach Anspruch 1, wobei das maschinelle Lernen durch ein künstliches neuronales Netzwerk (ANN) durchgeführt wird.

5. Das elektronische System nach Anspruch 1, wobei das maschinelle Lernen Dynamic Time Warping (DTW) umfasst.

6. Das elektronische System nach Anspruch 1, wobei der Betriebsparameter mindestens einen der folgenden Werte umfasst: Frequenz, Spannung, Strom und Temperatur.

7. Das elektronische System nach Anspruch 1, wobei die Steuerung eine Maintenance-as-a-Service-(MAAS-)Cloud-Computing-Steuerung umfasst.

8. Das elektronische System nach Anspruch 1, wobei die Kommunikationsschaltung einen Radiofrequenz-(RF-)Transceiver umfasst; wobei der Prozessor so konfiguriert ist, dass er die RF-Kommunikation unterbricht, wenn der mindestens eine Verschlüsselungsschlüssel gelöscht wird; und wobei die nicht wiederaufladbare Batterie so konfiguriert ist, dass sie den flüchtigen Speicher mit Strom versorgt, wenn die wiederaufladbare Batterie vom tragbaren Gehäuse getrennt wird, damit der mindestens eine Verschlüsselungsschlüssel nicht gelöscht wird.

9. Das elektronische System nach Anspruch 1, wobei die interne Widerstandsmessschaltung so konfiguriert ist, dass sie die internen Widerstandswerte auf der Grundlage einer Impulsimpedanz-Überwachung misst.

10. Ein Verfahren zum Betreiben eines elektronischen Systems gemäß einem der Ansprüche 1 bis 9.

## Revendications

1. Un système électronique (30) comprenant:
un dispositif électronique (31) comprenant
un boîtier portable (34),
des circuits de communication (35) portés par le boîtier portable,
une mémoire volatile (33) portée par le boîtier portable et configurée pour stocker au moins une clé de chiffrement,
une batterie non rechargeable (32) portée par le boîtier portable et couplée à la mémoire volatile, la batterie non rechargeable ayant une résistance interne,
un circuit de mesure de résistance interne (36) porté par le boîtier portable et configuré pour mesurer la résistance interne de la batterie non rechargeable,
un processeur (37) porté par le boîtier portable et configuré pour collecter et stocker des données de performance de la batterie, y compris la résistance interne mesurée et un paramètre de fonctionnement correspondant, et
une batterie rechargeable (40) couplée de manière amovible au boîtier portable et configurée pour alimenter la mémoire volatile, la batterie non rechargeable alimentant la mémoire volatile dans le cas contraire; et
un contrôleur (41) configuré pour collecter les données de performance de la batterie et utiliser l'apprentissage automatique pour déterminer l'état de santé (SoH) de la batterie non rechargeable.

2. Le système électronique selon la revendication 1, dans lequel le contrôleur est configuré pour:
générer des données d'apprentissage « run to fail » (RTF) pour la batterie non rechargeable sur la base de différentes combinaisons de mesures de résistance interne et de paramètres de fonctionnement; et
déterminer l'état de santé (SoH) de la batterie non rechargeable sur la base de la correspondance des modèles d'apprentissage automatique et des données de performance de la batterie téléchargées.

3. Le système électronique selon la revendication 1, dans lequel le contrôleur est configuré pour générer une alerte lorsque le SoH tombe en dessous d'un seuil SoH.

4. Le système électronique selon la revendication 1, dans lequel l'apprentissage automatique est effectué par un réseau neuronal artificiel (ANN).

5. Le système électronique selon la revendication 1, dans lequel l'apprentissage automatique comprend une transformation temporelle dynamique (DTW).

6. Le système électronique selon la revendication 1, dans lequel le paramètre de fonctionnement comprend au moins l'un parmi la fréquence, la tension, le courant et la température.

7. Le système électronique selon la revendication 1, dans lequel le contrôleur comprend un contrôleur de cloud computing Maintenance as a Service (MAAS).

8. Le système électronique selon la revendication 1, dans lequel le circuit de communication comprend un émetteur-récepteur radiofréquence (RF); dans lequel le processeur est configuré pour interrompre les communications RF si la au moins une clé de chiffrement est effacée; et dans lequel la batterie non rechargeable est configurée pour alimenter la mémoire volatile lorsque la batterie rechargeable est déconnectée du boîtier portable, de sorte que la au moins une clé de chiffrement ne soit pas effacée.

9. Le système électronique selon la revendication 1, dans lequel le circuit de mesure de résistance interne est configuré pour mesurer les valeurs de résistance interne sur la base d'une surveillance de l'impédance d'impulsion.

10. Une méthode de fonctionnement d'un système électronique selon l'une quelconque des revendications 1 à 9.
